# EUROPÄISCHE PATENTSCHRIFT

(11) **EP 1 314 343 B1**
(45) Veröffentlichungstag und Bekanntmachung des Hinweises auf die Patenterteilung: **23.07.2008**
(21) Anmeldenummer: 01969606.1
(22) Anmeldetag: 17.08.2001
(51) Int. Cl.: H05K 7/14

(54) **FRONTSYSTEM MIT INTEGRIERTEM ELEKTRISCHEN ANZEIGEELEMENT**
FRONT SYSTEM COMPRISING AN INTEGRATED ELECTRIC DISPLAY ELEMENT
SYSTEME FRONTAL A ELEMENT D'AFFICHAGE ELECTRIQUE INTEGRE

(30) Priorität: 17.08.2000 DE 20014198 U
(43) Veröffentlichungstag der Anmeldung: 28.05.2003
(73) Patentinhaber: Rittal Electronic Systems GmbH & Co. KG, 35745 Herborn (DE)
(72) Erfinder: KOERBER, Werner, 91282 Betzenstein (DE); SCHAFFER, Kurt, Michael, 90542 Eckental (DE); BEHRENS, Ralf, 90419 Nürnberg (DE); KURRER, Siegfried, 90449 Nürnberg (DE)
(74) Vertreter: Fleck, Hermann-Josef
(86) Internationale Anmeldenummer: PCT/EP2001/009520
(87) Internationale Veröffentlichungsnummer: WO 2002/019785

(56) Entgegenhaltungen:
- WO-A-96/42187
- US-A- 5 627 379
- PATENT ABSTRACTS OF JAPAN vol. 1995, no. 06, 31. Juli 1995 (1995-07-31) & JP 07 058462 A (NEC CORP), 3. März 1995 (1995-03-03)
- PATENT ABSTRACTS OF JAPAN vol. 2000, no. 02, 29. Februar 2000 (2000-02-29) & JP 11 307964 A (TOSHIBA CORP), 5. November 1999 (1999-11-05)

## Beschreibung

Die Erfindung betrifft ein Frontsystem für eine in einem Baugruppenträger einschiebbare Flachbaugruppe mit den Merkmalen des Oberbegriffs des Patentanspruchs 1 sowie einen Hebelziehgriff angebracht an einem Endstück für ein derartiges Frontsystem.

Aus der WO 96/42187 ist ein Frontsystem für eine Flachbaugruppe mit Aktiv-Passiv-Schaltung bekannt, wobei das Frontsystem je ein im oberen bzw. unteren vorderen Eckbereich der Flachbaugruppe angebrachtes oberes bzw. unteres Endstück aufweist. Daran sind jeweils ein oberer bzw. unterer Hebelziehgriff zum Ein-/Aushebeln der Flachbaugruppe in und aus dem Baugruppenträger angebracht.

Ferner sind Mittel vorhanden, über die der jeweilige Hebelziehgriff bei Erreichen des in den Baugruppenträger eingeschobenen Zustands der Flachbaugruppe in der entsprechenden Position fixiert wird. Im oberen oder unteren Endstück ist ein Schaltelement integriert, welches durch den entsprechenden Hebelziehgriff bei Vorliegen von dessen fixierter Position betätigt wird. Hierüber kann die Flachbaugruppe elektrisch freigeschaltet werden. Etwaige elektrische Anzeigeelemente, die z.B. den Schaltzustand des Schaltelements des Frontsystems anzeigen, sind dabei üblicherweise separat in der Frontplatte des Frontsystems integriert, wofür separater Bauraum benötigt wird.

Der Erfindung liegt die Aufgabe zugrunde, ein Frontsystem für eine Flachbaugruppe anzubieten, welches ein besonders platzsparend angebrachtes elektrisches Anzeigeelement aufweist.

Ferner soll ein Hebelziehgriff angebracht an einem Endstück für ein derartiges Frontsystem angeboten werden.

Diese Aufgabe wird für das Frontsystem durch die Merkmale des kennzeichnenden Teils des Patentanspruchs 1 in Verbindung mit den Merkmalen des Oberbegriffs gelöst. Vorteilhafte Ausführungsformen der Erfindung werden in den Unteransprüchen 2 - 12 realisiert. Für den Hebelziehgriff wird die Aufgabe durch die Merkmale des Patentanspruchs 13 gelöst.

Beim erfindungsgemäßen Frontsystem weist das obere bzw. untere Endstück, welches im oberen bzw. unteren vorderen Eckbereich der Flachbaugruppe angebracht ist, ein elektrisches Anzeigeelement auf. Hierdurch kann z.B. der Schaltzustand des im Endstück integrierten Schaltelements des Frontsystems angezeigt werden. Im Gegensatz zum geschilderten Stand der Technik wird beim erfindungsgemäßen Frontsystem kein separater Bauraum z.B. in der Frontplatte des Frontsystems benötigt. Das elektrische Anzeigeelement ist erfindungsgemäß platzsparend und kompakt am Endstück des Frontsystems angebracht.

Das Anzeigeelement kann auf vielfältige Art und Weise mit dem Endstück verbunden und z.B. modulartig oder als Ergänzungsbauteil an der Außenseite des Endstücks angebracht sein.

Eine besonders bauraumsparende Lösung wird erreicht, wenn das Anzeigeelement teilweise oder vollständig in das Endstück integriert ist und somit die Oberfläche des Anzeigeelementes gegenüber der bisherigen Oberfläche des Endstücks nur wenig zusätzlichen Bauraum benötigt oder bündig mit einer Oberfläche des Endstücks abschließt. Insbesondere bei einer integrierten Aufnahme des Anzeigeelementes im Endstück kann dieses hierfür eine Ausnehmung aufweisen, in welcher das Anzeigeelement verbindungssicher aufgenommen ist.

Wenn das Anzeigeelement im oder am Endstück benachbart zum im Endstück integrierten Schaltelement des Frontsystems angebracht ist, können sowohl das Anzeigeelement als auch das Schaltelement mit geringerem Aufwand montiert und mit gemeinsamen elektrischen Anschlusskontakten versehen werden.

Bei einer einstückigen Verbindung des Anzeigeelements mit dem Schaltelement kann ein derartiges Kombi-Element in einem Montageschritt am Endstück angebracht werden. Ferner kann das Anzeigeelement über eine integrierte elektrische Verbindung elektrisch mit dem Schaltelement und dessen Anschlusskontakten verbunden sein.

Wenn das Schaltelement vertieft im Endstück des Frontsystem angebracht ist, kann insbesondere bei einem mit dem Schaltelement verbundenen Anzeigeelement erreicht werden, dass die Oberfläche des Anzeigeelements weitgehend bündig mit einer Oberfläche des Endstücks abschließt und somit kein zusätzlicher Bauraum benötigt wird.

Der erfindungsgemäße Hebelziehgriff ist angebracht an einem Endstück für ein Frontsystem mit den Merkmalen der Ansprüche 1- 12 wobei das Endstück ein elektrisches Anzeigeelement aufweist. Das Anzeigeelement ist kompakt und platzsparend am Endstück angebracht.

Die Erfindung ist anhand von Ausführungsbeispielen in den Zeichnungsfiguren näher erläutert. Es zeigen:
- FIG 1: eine Darstellung eines Frontsystems für eine Flachbaugruppe nach dem Stand der Technik,
- FIG 2: eine Darstellung eines erfindungsgemäßen Frontsystems mit elektrischem Anzeigeelement im Endstück sowie
- FIG 3: ein Längsschnitt durch den Hebelziehgriff des Frontsystems nach FIG 2.

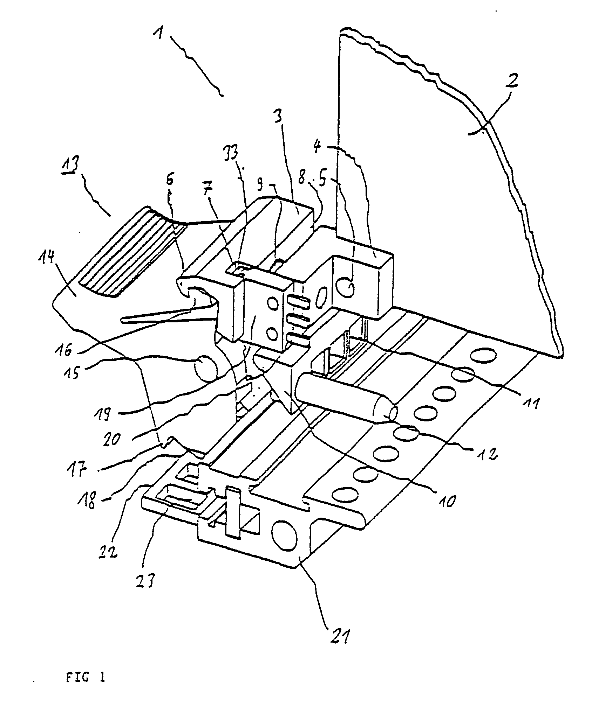

FIG 1 zeigt in einer perspektivischen Seitenansicht ein Frontsystem nach dem Stand der Technik für eine Flachbaugruppe. Dabei ist der untere, vordere Endbereich 1 eines derartigen Frontsystems für eine Flachbaugruppe dargestellt, welche in Form ihres unteren, vorderen Eckbereichs 2 ausschnittsweise dargestellt ist. Der untere Endbereich 1 ruht dabei auf der unteren Querschiene 21 eines Baugruppenträgers und weist dabei als Hauptkomponenten einen unteren Hebelziehgriff 13, ein unteres Endstück 3 und eine aus Gründen der Übersichtlichkeit nicht dargestellte Frontplatte auf. Dem unteren Endstück 3 kommt dabei eine zentrale Haltefunktion zu, da es zum einen als Träger für den insbesondere über einen Bohrungszapfen 15 drehbar gelagerten Hebelziehgriff 13 dient. Andererseits kann es auch zur Halterung des unteren Endes der nicht abgebildeten Frontplatte dienen, welche hierzu vorteilhaft in eine Nut 8 eingeschoben und über eine in eine Bohrung 9 eingreifende Schraube gehalten wird. Die Verbindung zwischen dem unteren Endstück 3 und dem vorderen, unteren Ecke der Flachbaugruppe erfolgt bevorzugt über einen Halteblock 4 mittels einer in eine Bohrung 5 eingreifenden Schraube.

Schließlich können noch weitere Komponenten an einem derartigen Endstück 3 angebracht sein. So enthält das in FIG 1 dargestellte Endstück 3 einen Kodierblock 10, in welchen Kodierkammern 11 zum Einsetzen von nicht abgebildeten Kodierstiften eingebracht sind. Diese können in gegenüberliegend an der unteren Querschiene 21 angebrachten Kodierkammern eingreifen, welche mit komplementär kodierten Kodierstiften bestückt sind. Hiermit kann sichergestellt werden, dass nur eine bestimmte, ausgewählte Flachbaugruppe in einem Steckplatz eines Baugruppenträgers positionierbar ist. Schließlich ist noch ein Führungsstift 12 vorhanden, welcher nach Eingriff in eine gegenüberliegende nicht abgebildete Führungsbohrung ein verkantfreies, ordnungsgemäßes Einschieben der Flachbaugruppe gewährleistet.

Zum Ein- bzw. Aushebeln der Flachbaugruppe in den bzw. aus dem entsprechenden Steckplatz dient der untere Hebelziehgriff 13, welcher durch Betätigung des Griffteils 14 bedient werden kann.

Beim Aushebeln muss der Hebelziehgriff 19 nach unten gedrückt werden, so dass sich mindestens eine auf der Unterseite vorspringende Aushebelnase 17 an einer Stirnkante 22 der unteren Querschiene 21 abstützen kann. Umgekehrt muss beim Einhebeln der Hebelziehgriff 19 nach oben gedrückt werden, so dass sich mindestens eine ebenfalls auf der Unterseite vorspringende Einhebelkante 18 im Inneren einer ebenfalls im Bereich der Stirnkante 22 der unteren Querschiene 21 befindlichen mindestens einen Eingriffsmulde 23 abstützen kann.

Üblicherweise sind am Endstück 3 noch Mittel vorhanden, über die der Hebelziehgriff 13 bei Erreichen des in den Baugruppenträger vollständig eingeschobenen Zustands der Flachbaugruppe in der entsprechenden Position fixiert wird. Dieser eingeschobene Zustand ist in FIG 1 dargestellt.

Vorteilhafterweise weist der Hebelziehgriff 13 hierzu auf seiner Oberseite eine auf das Endstück 3 gerichtete, federnde und nach oben stehende Rastnase 16 auf, welche eine auf den Hebelziehgriff 13 gerichtete und nach unten abgehende Rastkante 6 am Endstück 3 hintergreift.

In der gleichen Weise ist auch an dem in FIG 1 nicht dargestellten vorderen, oberen Eckbereich 2 der Flachbaugruppe eine entsprechende Anordnung aus einem oberen Endstück 3 mit einem daran drehbar gelagerten oberen Hebelziehgriff 13 angebracht. Diese greift dann zum Ein- und Aushebeln in eine entsprechende obere Querschiene eines Baugruppenträgers ein.

Bei dem Frontsystem nach dem Stand der Technik gemäß FIG 1 ist im unteren oder oberen Endstück ein Schaltelement 19 integriert, wobei dieses durch den entsprechenden Hebelziehgriff bei Vorliegen von dessen fixierter Position betätigt wird. Es ist hiermit möglich, die Flachbaugruppe elektrisch freizuschalten, z.B. durch Aktivierung von deren Stromversorgung. Umgekehrt kann die Flachbaugruppe auch elektrisch passiv geschaltet werden, indem im Moment einer Aushebelung der Flachbaugruppe der Eingriff des Hebelziehgriffs auf das in das Endstück 3 integrierte Schaltelement 19 endet und durch diese Freigabe des Schaltelements 19 z.B. die elektrische Stromversorgung der Flachbaugruppe wieder passiviert wird.

In FIG 1 ist beispielhaft ein in das untere Endstück 3 integriertes Schaltelement 19 dargestellt. Dieses ist in einem bis in den Bereich der Rastkante 6 des Endstücks 3 reichenden Aufnahmeschlitz 7 gelagert. Ein Schaltteil des Schaltelements 19, z.B. ein Schalthebel 33, ragt somit in den Bereich unterhalb der nach unten abgehenden Rastkante 6 hinein und wird bei Erreichen des fixierten Zustands des Hebelziehgriffs 13 durch dessen auftreffende (nicht einsehbare) Hinterseite betätigt.

Im Beispiel der FIG 1 kann diese Betätigung durch die dem unteren Endstück 3 zugewandte Stirnseite der Rastnase 16 erfolgen.

Vorteilhafterweise ist das integrierte Schaltelement 19 über eine an Anschlusskontakten 20 anbringbare Kabel- oder Kabelsteckverbindung mit der Flachbaugruppe elektrisch verbindbar. es sind aber auch andersartige Verbindungen möglich. So können z.B. die Anschlusskontakte drahtförmig bis auf die Oberfläche der Flachbaugruppe heruntergezogen und in dort vorhandene Bohrungen 5 oder 9 verlötet werden. Das abgebildete Frontsystem hat den Vorteil, dass durch Integration des Schaltelements 19 in ein unteres oder oberes Endstücks 3 des Frontsystems einer.Flachbaugruppe dieses sehr exakt in eine genau definierbare Position verbracht werden kann.

Es ist somit auch dann möglich, das Schaltelement 19 dauerhaft sicher und verschleißfrei über den Hebelziehgriff 13 zu betätigen, wenn die Schaltmittel des Schaltelements 19 nur einen sehr geringen Schaltweg aufweisen. Da die Aktiv-Passiv-Schaltfunktion vollständig in das Frontsystem integriert ist, unterliegen Anwender des Frontsystems keiner Einschränkung bezüglich der Positionierung von Bauelementen auf einer mit einem derartigen Frontsystem ausgestatteten Flachbaugruppe.

Insbesondere sind dort keine maßlich genauen Positionsfestlegungen bezüglich elektrischer Anschlüsse für das Schaltelement 19 erforderlich.

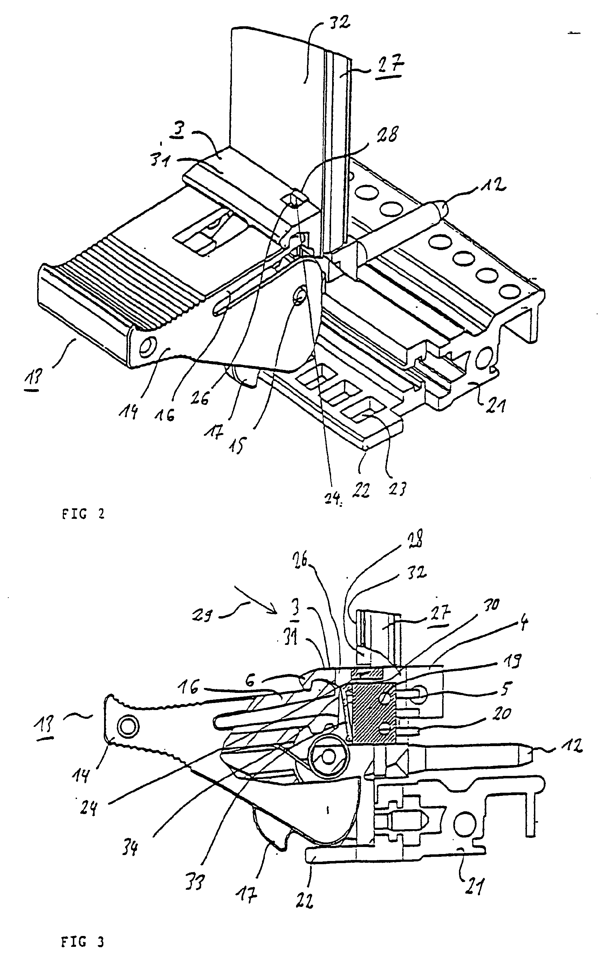

Während beim beschriebenen Frontsystem nach dem Stand der Technik gemäß FIG 1 elektrische Anzeigeelemente in einer aus Gründen der Übersichtlichkeit nicht dargestellten Frontplatte des Frontsystems aufgenommen ist, welche in der Nut 8 eingeschoben wird, weist das erfindungsgemäße Frontsystem gemäß FIG 2 und 3 ein elektrisches Anzeigeelement 24 im Endstück 3 des erfindungsgemäßen Frontsystems auf.

Das elektrische Anzeigeelement 24 kann dabei z.B. als LED-Element ausgebildet sein und den Schaltzustand eines in den Schalter des erfindungsgemäßen Frontsystems integrierten Schaltelements 19 anzeigen. Soweit der Aufbau des erfindungsgemäßen Frontsystems gemäß den FIG 2 und 3 dem Aufbau des Frontsystem nach dem Stand der Technik gemäß FIG 1 entspricht, wurden identische Bezugszeichen verwendet, welche auch ohne ergänzende Erläuterung auch die bei der Figurenbeschreibung nach FIG 1 dargestellte Funktion besitzen.

Das Anzeigeelement 24 ist im Frontsystem nach FIG 2 in einer Ausnehmung 26 des Endstücks 3 sowie in einer Ausnehmung 28 der Frontplatte 27 aufgenommen, welche aus Gründen der Übersichtlichkeit in der Darstellung nach FIG 1 nicht abgebildet wurde. Damit benötigt das derart vertieft aufgenommene Anzeigeelement 24 keinen zusätzlichen Bauraum gegenüber der Oberfläche 31 des Endstücks 3 und der Oberfläche 32 der Frontplatte 27.

In der Längsschnittdarstellung des erfindungsgemäßen Frontsystem nach FIG 3 wird die Anordnung des Anzeigeelements 24 insbesondere gegenüber dem Schaltelement 19 beschrieben. Dabei ist das Anzeigeelement 24 benachbart und oberhalb des vertieft angeordneten Schaltelements 19 angebracht und kann aus Blickrichtung 29 vom Benutzer des Frontsystems eingesehen werden. Das Anzeigeelement 24 kann über die Anschlusskontakte 20 des Schaltelements 19 mit Strom versorgt werden oder eine separate Stromversorgung mit separaten Anschlusskontakten aufweisen (nicht abgebildet). Ferner kann das Anzeigeelement 24 einstückig und ohne Zwischenraum 30 mit dem Schaltelement 19 verbunden sein und als ein derartiges Kombi-Element besonders montagefreundlich ausgebildet sein (ebenfalls nicht abgebildet).

Aus FIG 3 geht auch die Betätigung des Schalthebels 33 des Schaltelements 19 durch die Hinterseite 34 der Rastnase 16 des Hebelziehgriffs 13 bei dessen vorliegendem fixierten Zustand hervor. Der Schaltzustand dieses Schalthebels 33 und damit der Schaltzustand des Schaltelements 19 können erfindungsgemäß durch Aufleuchten oder Erlöschen des Anzeigeelements 24 angezeigt werden.

Das Schaltelement 19 des erfindungsgemäßen Frontsystems gemäß FIG 2 und 3 ist verglichen mit dem Schaltsystem 19 nach FIG 1 nach dem Stand der Technik vertieft im Endstück 3 angeordnet, so dass oberhalb des Schaltelements 19 das Anzeigeelement 24 angebracht werden kann (vgl. FIG 3). Der Schalthebel 33 eines derart vertieft angeordneten Schaltelements 19 kann durch eine verglichen mit einem Frontsystem nach dem Stand der Technik gemäß FIG 1 entsprechend nach unten - in Richtung des Querträgers 21 - verlängerte Hinterseite 34 der Rastnase 16 des Hebelziehgriffs. 13 kontaktiert und betätigt werden.

## Patentansprüche

1. Frontsystem für eine in einen Baugruppenträger einschiebbare Flachbaugruppe, mit
a) je einem im oberen oder unteren vorderen Eckbereich (2) der Flachbaugruppe angebrachten oberen oder unteren Endstück (3),
b) je einem am oberen oder unteren Endstück (3) angebrachten oberen oder unteren Hebelziehgriff (13) zum Ein- und Aushebeln der Flachbaugruppe in und aus dem Baugruppenträger, welche Mittel aufweisen, über die der jeweilige Hebelziehgriff (13) bei Erreichen des in den Baugruppenträger eingeschobenen Zustands der Flachbaugruppe in der entsprechenden Position fixiert wird und mit
c) einem im oberen oder unteren Endstück (3) derart integrierten Schaltelement (19), dass dieses durch den entsprechenden Hebelziehgriff (13) bei Vorliegen von dessen fixierter Position betätigt wird,
**dadurch gekennzeichnet, dass** das obere oder untere Endstück (3) ein elektrisches Anzeigeelement (24) aufweist.

2. Frontsystem nach Anspruch 1,
**dadurch gekennzeichnet, dass** das elektrische Anzeigeelement (24) an der Außenseite (25) des Endstücks (3) angebracht ist.

3. Frontsystem nach Anspruch 1 oder 2,
**dadurch gekennzeichnet, dass** das Anzeigeelement (24) teilweise in das Endstück (3) integriert ist.

4. Frontsystem nach Anspruch 1 oder 2,
**dadurch gekennzeichnet, dass** Anzeigeelement (24) vollständig in das Endstück (3) integriert ist.

5. Frontsystem nach einem der vorhergehenden Ansprüche,
**dadurch gekennzeichnet, dass** das Endstück (3) eine Ausnehmung (26) zur Aufnahme des Anzeigeelements (24) aufweist.

6. Frontsystem nach einem der vorhergehenden Ansprüche,
**dadurch gekennzeichnet, dass** eine Frontplatte (27) eine Ausnehmung (28) zur Aufnahme des Anzeigeelements (24) aufweist.

7. Frontsystem nach einem der vorhergehenden Ansprüche,
**dadurch gekennzeichnet, dass** das Anzeigeelement (24) benachbart zum Schaltelement (19) angebracht ist.

8. Frontsystem nach einem der vorhergehenden Ansprüche,
**dadurch gekennzeichnet, dass** das Anzeigeelement (24) einstückig mit dem Schaltelement (19) verbunden ist.

9. Frontsystem nach einem der vorhergehenden Ansprüche,
**dadurch gekennzeichnet, dass** das Schaltelement (19) vertieft im Endstück (3) angebracht ist.

10. Frontsystem nach einem der vorhergehenden Ansprüche,
**dadurch gekennzeichnet, dass** das Anzeigeelement (24) eine separate Stromversorgung aufweist.

11. Frontsystem nach einem der vorhergehenden Ansprüche,
**dadurch gekennzeichnet, dass** Anzeigeelement (24) elektrisch mit dem Schaltelement (19) verbunden ist.

12. Frontsystem nach Anspruch 11,
**dadurch gekennzeichnet, dass** das Anzeigeelement (24) über Anschlusskontakte (20) des Schaltelements (19) mit Strom versorgt wird.

13. Hebelziehgriff (13) angebracht an einem oberen oder unteren Endstück (3) für ein Frontsystem nach einem der Ansprüche 1 - 12, **dadurch gekennzeichnet, dass** das obere oder untere Endstück ein elektrisches Anzeigeelement aufweist.

## Claims

1. Front system for a printed circuit board assembly which can be inserted into a mounting rack, comprising
a) in each case an upper or lower end piece (3) which is fitted in the upper or lower front corner region (2) of the printed circuit board assembly,
b) in each case an upper or lower lever pull handle (13), which is fitted to the upper or lower end piece (3), for levering the printed circuit board assembly into and out of the mounting rack, which lever pull handles have means with which the respective lever pull handle (13) is fixed in the corresponding position when the state in which the printed circuit board assembly is inserted into the mounting rack is reached, and comprising
c) a switching element (19) which is integrated in the upper or lower end piece (3) in such a way that the said switching element is operated by the corresponding lever pull handle (13) when it is in its fixed position,
**characterized in that** the upper or lower end piece (3) has an electrical display element (24).

2. Front system according to Claim 1,
**characterized in that** the electrical display element (24) is fitted to the outer face (25) of the end piece (3).

3. Front system according to Claim 1 or 2,
**characterized in that** the display element (24) is partially integrated in the end piece (3).

4. Front system according to Claim 1 or 2,
**characterized in that** the display element (24) is fully integrated in the end piece (3).

5. Front system according to one of the preceding claims,
**characterized in that** the end piece (3) has a recess (26) for accommodating the display element (24).

6. Front system according to one of the preceding claims,
**characterized in that** a front panel (27) has a recess (28) for accommodating the display element (24).

7. Front system according to one of the preceding claims,
**characterized in that** the display element (24) is fitted adjacent to the switching element (19).

8. Front system according to one of the preceding claims,
**characterized in that** the display element (24) is integrally connected to the switching element (19).

9. Front system according to one of the preceding claims,
**characterized in that** the switching element (19) is fitted such that it is recessed in the end piece (3).

10. Front system according to one of the preceding claims,
**characterized in that** the display element (24) has a separate power supply.

11. Front system according to one of the preceding claims,
**characterized in that** the display element (24) is electrically connected to the switching element (19).

12. Front system according to Claim 11,
**characterized in that** the display element (24) is supplied with power via connection contacts (20) of the switching element (19).

13. Lever pull handle (13) fitted to an upper or lower end piece (3) for a front system according to one of Claims 1-12, **characterized in that** the upper or lower end piece has an electrical display element.

## Revendications

1. Système frontal pour un groupe structurel plat susceptible d'être inséré dans un support de groupe structurel, avec
a) chaque fois une pièce d'extrémité (3) supérieure ou inférieure montée dans la région angulaire supérieure ou inférieure (2) du groupe structurel plat,
b) chaque fois une poignée de tirage à levier (13) supérieure ou inférieure montée sur la pièce d'extrémité (3) supérieure ou inférieure, pour faire rentrer ou sortir par un mouvement de levier le groupe structurel plat dans ou hors du support de groupe structurel, qui comporte des moyens, par l'intermédiaire desquels la poignée de tirage à levier (13) concernée est fixée dans la position correspondante, à l'atteinte par le groupe structurel de l'état inséré dans le support de groupe structurel et avec
c) un élément de commutation (19), intégré dans la pièce d'extrémité (3) supérieure ou inférieure, de sorte que celui-ci soit actionné par la poignée de tirage à levier (13) correspondante, lorsque cette dernière est dans la position fixée,
**caractérisé en ce que** la pièce d'extrémité (3) supérieure ou inférieure comporte un élément d'affichage électrique (24).

2. Système frontal selon la revendication 1,
**caractérisé en ce que** l'élément d'affichage électrique (24) est monté sur la face extérieure (25) de la pièce d'extrémité (3).

3. Système frontal selon la revendication 1 ou 2,
**caractérisé en ce que** l'élément d'affichage (24) est partiellement intégré dans la pièce d'extrémité (3).

4. Système frontal selon la revendication 1 ou 2,
**caractérisé en ce que** l'élément d'affichage (24) est entièrement intégré dans la pièce d'extrémité (3).

5. Système frontal selon l'une quelconque des revendications précédentes,
**caractérisé en ce que** la pièce d'extrémité (3) comporte un évidement (26) pour le logement de l'élément d'affichage (24).

6. Système frontal selon l'une quelconque des revendications précédentes,
**caractérisé en ce qu'**un panneau frontal (27) comporte un évidement (28) pour le logement de l'élément d'affichage (24).

7. Système frontal selon l'une quelconque des revendications précédentes,
**caractérisé en ce que** l'élément d'affichage (24) est monté au voisinage de l'élément de commutation (19).

8. Système frontal selon l'une quelconque des revendications précédentes,
**caractérisé en ce que** l'élément d'affichage (24) est assemblé en monobloc avec l'élément de commutation (19).

9. Système frontal selon l'une quelconque des revendications précédentes,
**caractérisé en ce que** l'élément de commutation (19) est monté en retrait dans la pièce d'extrémité (3).

10. Système frontal selon l'une quelconque des revendications précédentes,
**caractérisé en ce que** l'élément d'affichage (24) comporte une alimentation électrique séparée.

11. Système frontal selon l'une quelconque des revendications précédentes,
**caractérisé en ce que** l'élément d'affichage (24) est électriquement relié avec l'élément de commutation (19).

12. Système frontal selon la revendication 11,
**caractérisé en ce que** l'élément d'affichage (24) est alimenté en courant via des contacts de raccordement (20) de l'élément de commutation (19).

13. Poignée de tirage à levier (13) montée sur une pièce d'extrémité (3) supérieure ou inférieure pour un système frontal selon l'une quelconque des revendications 1 à 12, **caractérisée en ce que** la pièce d'extrémité supérieure ou inférieure comporte un élément d'affichage électrique.
